# EUROPÄISCHE PATENTSCHRIFT

(11) **EP 1 148 511 B1**
(45) Veröffentlichungstag und Bekanntmachung des Hinweises auf die Patenterteilung: **17.01.2007**
(21) Anmeldenummer: 01107868.0
(22) Anmeldetag: 10.04.2001
(51) Int. Cl.: G11C 11/15, G11C 11/16

(54) **MRAM-Speicher**
MRAM memory
Mémoire MRAM

(30) Priorität: 14.04.2000 DE 10020128
(43) Veröffentlichungstag der Anmeldung: 24.10.2001
(73) Patentinhaber: Infineon Technologies AG, 81669 München (DE)
(72) Erfinder: Schuster-Woldan, Hans, 82237 Woerthsee (DE); Schwarzl, Siegfried, 85579 Neubiberg (DE)
(74) Vertreter: Reinhard - Skuhra - Weise & Partner

(56) Entgegenhaltungen:
- DE-A- 19 744 095
- US-A- 5 940 319
- US-A- 6 153 443

## Beschreibung

Die Erfindung betrifft einen MRAM-Speicher, bei dem die Ansteuerlogik zur Ansteuerung der magnetoresistiven Speicherbauelemente in einem Speicherzellenfeld des MRAM-Speichers unterhalb des Speicherzellenfeldes in und auf dem Halbleitersubstrat integriert ist.

MRAM-Speicherbauelemente weisen ferromagnetische Schichten auf, wobei der Widerstand des Speicherbauelements von den Magnetisierungsrichtungen der ferromagnetischen Schichten abhängt. Bei paralleler Magnetisierung der ferromagnetischen Schichten ist der Widerstand des Speicherbauelements klein während bei einer antiparallelen Magnetisierung der ferromagnetischen Schichten der Widerstand des Speicherbauelements groß ist.

Je nach Aufbau der Schichtstruktur des MRAM-Speicherbauelements wird unterschieden zwischen einem GMR-Speicherbauelement, einem TMR-Speicherbauelement, einem AMR-Speicherbauelement und einem CMR-Speicherbauelement.

Ein GMR-Speicherbauelement weist mindestens zwei ferromagnetische Schichten und eine dazwischen angeordnete nicht-magnetische leitende Schicht auf, wobei das GMR-Speicherbauelement einen sogenannten GMR- Effekt (GMR: Giant Magneto Resistance) zeigt, bei dem der elektrische Widerstand des GMR-Speicherbauelements davon abhängt, ob die Magnetisierungen in den beiden ferromagnetischen Schichten parallel oder antiparallel ausgerichtet sind.

Ein TMR-Speicherbauelement (TMR: Tunneling Magneto Resistance) weist mindestens zwei ferromagnetische Schichten auf und eine dazwischen angeordnete isolierende nicht-magnetische Schicht auf. Die isolierende Schicht ist dabei so dünn ausgebildet, daß es zu einem Tunnelstrom zwischen den beiden ferromagnetischen Schichten kommt. Die ferromagnetischen Schichten zeigen einen magnetoresistiven Effekt, der durch einen spinpolarisierten Tunnelstrom durch die zwischen den beiden ferromagnetischen Schichten angeordnete isolierende, nicht-magnetische Schicht bewirkt wird. Der elektrische Widerstand des TMR-Speicherbauelement hängt davon ab, ob die Magnetisierungen der beiden ferromagnetischen Schichten parallel oder anti-parallel ausgerichtet sind.

Bei dem AMR-Speicherbauelement ist der Widerstand der magnetisierten Leiter parallel und senkrecht zu der Magnetisierungsrichtung verschieden.

Beim CMR-Speicherbauelement (CMR= Colossal Magneto Resistance Effect) wird aufgrund hoher Koerzitiv-Kräfte ein hohes Magnetfeld zum Umschalten zwischen den Magnetisierungszuständen benötigt.

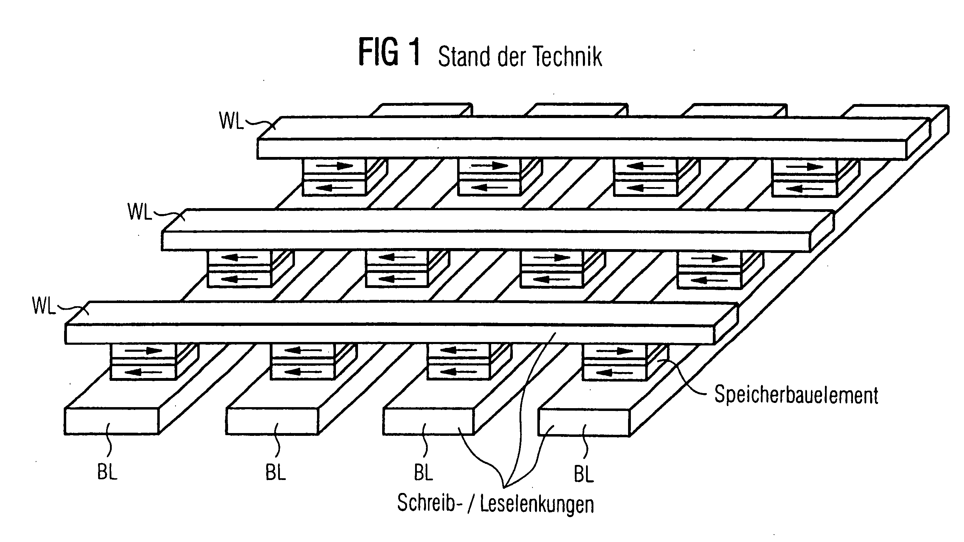

Fig. 1 zeigt ein Speicherzellenfeld eines MRAM-Speichers nach dem Stand der Technik, das aus einer Vielzahl metallischen Schreib-/Leseleitungen, auch Wort- und Bitleitungen genannt, die in x- und y-Richtung übereinander angeordnet sind und aus magnetoresistiven Speicherbauelementen, die jeweils zwischen zwei sich kreuzenden Schreib-/Leseleitungen und mit diesen leitend verbunden sind. Signale, die an die Wortleitungen WL oder Bitleitung BL angelegt werden, verursachen durch die durch die Wortleitungen WL bzw. Bitleitungen BL fließenden Ströme Magnetfelder, die bei hinreichender Stärke die darunter befindlichen Speicherbauelemente beeinflussen. Zum Einschreiben eines Datums bzw. einer Information in ein Speicherbauelement, das sich an einem Kreuzungspunkt einer Wortleitung WL und einer Bitleitung BL befindet, wird sowohl die Bitleitung BL als auch die Wortleitung WL mit einem Signal beaufschlagt. Die Stromsignale erzeugen jeweils Magnetfelder, die sich überlagern und zu einer Ummagnetisierung des Speicherbauelements führen. Die sich kreuzenden Wort- WL und Bitleitungen sind jeweils mit minimalen Abmessungen und Abständen mit einer minimalen Strukturgröße F herstellbar, so daß sich pro Speicherzellenlage ein Flächenbedarf von 4F² für jedes Speicherbauelement ergibt. MRAM-Speicher sind daher mit einer sehr hohen Packungsdichte herstellbar.

Gegenüber DRAM-Speichern zeichnen sich diese MRAM-Speicher dadurch aus, daß die einzelnen Speicherbauelemente keinen Auswahltransistor benötigen, sondern direkt an die Wort- und Bitleitungen angeschlossen sind. Das in Fig. 1 dargestellte Speicherzellenfeld weist lediglich eine Speicherzellenlage auf. Bei MRAM-Speichern können mehrere derartige Speicherzellenlagen übereinander angeordnet bzw. gestapelt werden. Die Abmessungen der Speicherbauelemente der herkömmlichen MRAM-Speicher liegen in einem Bereich von 0,05 µm bis 20 µm. Aufgrund der kleinen Größe der Speicherbauelemente, die keinen Auswahltransistor benötigen, und aufgrund der hohen möglichen Packungsdichte sowie aufgrund des möglichen mehrschichtigen Aufbaus kann bei MRAM-Speichern eine Vielzahl von Speicherbauelementen innerhalb eines sehr kleinen Raums integriert werden. Die in dem Speicherzellenfeld befindlichen magnetoresistiven Speicherbauelement werden über eine Ansteuerlogik angesteuert.

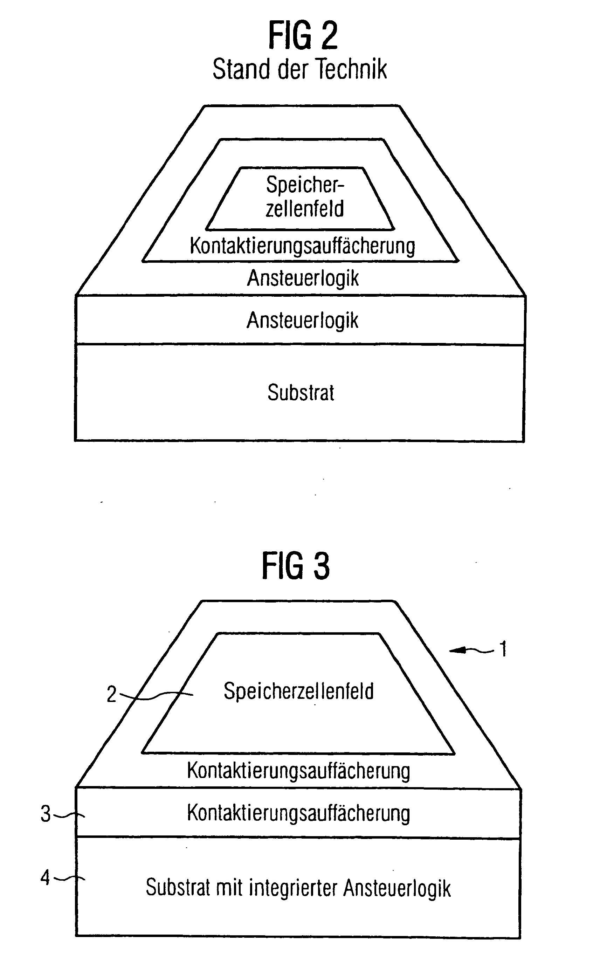

Fig. 2 zeigt den Aufbau eines MRAM-Speichers nach dem Stand der Technik. Das, aus den magnetoresistiven Speicherbauelementen bestehende Speicherzellenfeld ist über eine Kontaktierungsauffächerung mit der Ansteuerlogik verbunden, die um das Speicherzellenfeld herum angeordnet ist. Bei dem in Fig. 2 dargestellten herkömmlichen MRAM-Speicher befindet sich die Ansteuerlogik in der Peripherie des Halbleiterchips und liegt auf dem Halbleitersubstrat auf. Die Ansteuerlogik ist mit den Wort- und Bitleitungen verbunden. Wie man aus Fig. 3 erkennen kann, wird durch die peripher angeordnete Ansteuerlogik eine große Fläche auf dem Halbleitersubstrat eingenommen. Obwohl das aus magnetoresistiven Speicherbauelementen aufgebaute Speicherzellenfeld relativ wenig Platz einnimmt, benötigt der in Fig. 2 dargestellte herkömmliche MRAM-Speicher aufgrund der peripher angeordnete Ansteuerlogik insgesamt relativ viel Fläche auf dem Halbleitersubstrat.

Die US 5,940,319 offenbart ein Speicherzellenfeld mit magnetischen Speicherelementen, wobei die Herstellung in einen CMOS-Prozess integriert werden kann. Bei der US 5,940,319 muss für jede magnetische Speicherzelle ein Schalttransistor vorgehalten werden, wodurch praktisch das gesamte Halbleitersubstrat unterhalb des Speicherzellenfeldes verbraucht wird. Eine Ansteuerlogik zum Betrieb eines derartigen MRAM-Speichers erfordert so zusätzlichen Platzbedarf.

Es ist daher die Aufgabe der vorliegenden Erfindung, einen vollständigen MRAM-Speicher zu schaffen, der einen minimalen Flächenbedarf aufweist.

Diese Aufgabe wird erfindungsgemäß durch einen MRAM-Speicher mit den im Patentanspruch 1 angegebenen Merkmalen gelöst.

Bei einer bevorzugten Ausführungsform sind die magnetoresistiven Speicherbauelemente sowie die Wort- und Bitleitungen zur Kontaktierung der magnetoresistiven Speicherbauelemente in mehreren dielektrischen Schichten eingebettet.

Dabei sind die die Wort- und Bitleitungen vorzugsweise über Durchkontaktierungen, die durch die dielektrischen Schichten hindurchverlaufen, mit der in dem Halbleitersubstrat integrierten Ansteuerlogik verbunden.

Bei einer bevorzugten Ausführungsform entspricht der Durchmesser der Durchkontaktierungen etwa der minimalen Strukturgröße F.

Die Ansteuerlogik ist vorzugsweise eine CMOS-Logik.

Bei einer weiteren bevorzugten Ausführungsform weist ein Speicherbauelement jeweils zwei ferromagnetische Schichten und eine dazwischen angeordnete nicht-magnetische Schicht auf.

Ein Speicherbauelement des MRAM-Speichers weist vorzugsweise zwei Magnetisierungszustände auf.

Bei einer besonders bevorzugten Ausführungsform enthalten die beiden ferromagnetischen Schichten des Speicherbauelements jeweils mindestens eines der Elemente Fe, Ni, Co, Cr, Mn, Gd, Dy.

Die Dicke der ferromagnetischen Schichten des Speicherbauelements ist vorzugsweise kleiner oder gleich 20 nm.

Bei einer weiteren bevorzugten Ausführungsform des erfindungsgemäßen MRAM-Speichers enthält die nicht-magnetische Schicht mindestens eines der Materialie Al₂O₃, NiO, HfO₂, TiO₂, NbO und SiO₂.

Dabei liegt die Dicke der nicht-magnetischen Schicht vorzugsweise in einem Bereich zwischen 1 und 4 nm.

Bei einer weiteren bevorzugten Ausführungsform weist das Speicherbauelement eine antiferromagnetische Schicht auf, die zu einer der ferromagnetischen Schichten benachbart liegt und die Magnetisierungsrichtung in der benachbarten ferromagnetischen Schicht bestimmt.

Die antiferromagnetische Schicht enthält dabei vorzugsweise mindestens eines der Elemente Fe, Mn, Ni, Pt, Ir, Tb oder O.

Bei einer weiteren bevorzugten Ausführungsform liegen die Abmessungen eines Speicherbauelements in einem Bereich zwischen 0,05 µm und 20 µm.

Die Bitleitungen sind vorzugsweise mit einem Leseverstärker verbunden, über den das Potential an der jeweiligen Bitleitung auf ein Referenzpotential regelbar und an dem ein Ausgangssignal abgreifbar ist.

Der Leseverstärker enthält dabei vorzugsweise einen rückgekoppelten Operationsverstärker.

Bei einer besonders bevorzugten Ausführungsform liegt die Gesamtdicke eines einlagigen Speicherzellenfeldes mit den darunter- und darüberliegenden Bit- und Wortleitungen zwischen 400 und 1000 nm. Mehrlagige Speicherzellenfelder mit den zugehörigen Schreib- und Leseleitungen sind entsprechend um ein Viefaches dicker.

Bei einer weiteren bevorzugten Ausführungsform des erfindungsgemäßen MRAM-Speichers ist jede Wortleitung jeweils mit zwei magnetoresistiven Speicherbauelementen in zwei übereinander liegenden Speicherzellenlagen verbunden.

Dies bietet den besonderen Vorteil, daß die Anzahl der notwendigen Wortleitungen halbiert werden kann.

Im weiteren wird eine bevorzugten Ausführungsform des erfindungsgemäßen MRAM-Speichers unter Bezugnahme der beigefügten Figuren zur Erläuterung erfindungswesentlicher Merkmale beschrieben.

Es zeigen:
- Fig. 1: ein Speicherzellenfeld nach dem Stand der Technik;
- Fig. 2: eine schematische Darstellung der Anordnung eines herkömmlichen MRAM-Speichers;
- Fig. 3: eine schematische Darstellung der Anordnung des erfindungsgemäßen MRAM-Speicher;
- Fig. 4: eine erste Schnittansicht durch den erfindungsgemäßen MRAM-Speicher;
- Fig. 5: eine zweite Schnittansicht durch den erfindungsgemäßen MRAM-Speicher, wobei die zweite Schnittansicht senkrecht zu der in Fig. 4 dargestellten ersten Schnittansicht verläuft.

Fig. 3 zeigt den räumlichen Aufbau eines erfindungsgemäßen MRAM-Speichers 1. Der MRAM-Speicher 1 besteht aus einem Speicherzellenfeld 2, einer Kontaktierungsauffächerung 3 sowie aus einem Halbleitersubstrat 4, in und auf das eine Ansteuerlogik 5 integriert ist. Das Speicherzellenfeld 2 besteht aus magnetoresistiven Speicherbauelementen, die in mehreren Speicherzellenlagen über dem Halbleitersubstrat 4 angeordnet sind. Die in dem Speicherzellenfeld 2 enthaltenen Speicherbauelemente werden über gitterförmig verlaufende Wort- und Bitleitungen kontaktiert, die zur elektrischen Kontaktierung mit der Ansteuerlogik 5 in der Kontaktierungsauffächerung 3 aufgefächert werden.

Wie man aus Fig. 3 erkennen kann, befindet sich die in das Halbleitersubstrat 4 integrierte Ansteuerlogik unterhalb des Speicherzellenfeldes 2 und der Kontaktierungsauffächerung und nicht peripher um die Kontaktierungsauffächerung 3 herum, wie bei der in Fig. 2 dargestellten herkömmlichen räumlichen Anordnung. Der in Fig. 3 dargestellte erfindungsgemäße MRAM-Speicher 1 benötigt daher eine viel geringere Fläche auf dem Halbleitersubstrat 4. Die Flächeneinsparung gegenüber dem in Fig. 2 dargestellten herkömmlichen MRAM-Speicher beträgt bei dem in Fig. 3 dar-gestellten erfindungsgemäßen MRAM-Speicher bis zu 50%.

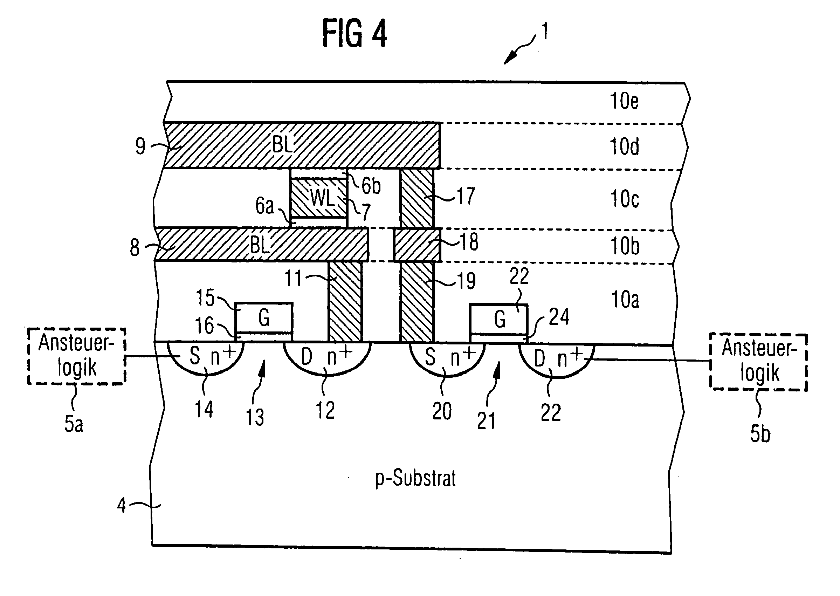

Fig. 4 zeigt eine erste Schnittansicht durch den erfindungsgemäßen MRAM-Speicher 1.

Bei der in Fig. 4 dargestellten Speicheranordnung weist das Speicherzellenfeld 2 zwei Speicherzellenlagen mit magnetoresistiven Speicherbauelementen 6a, 6b auf. Bei weiteren (nicht dargestellten) Ausführungsformen können eine Vielzahl von Speicherzellenlagen übereinander gestapelt sein.

Die magnetoresistiven Speicherbauelemente 6a, 6b in der ersten und zweiten Speicherzellenlage werden über eine gemeinsame Wortleitung 7 kontaktiert. Das in der ersten Speicherzellenlage befindliche Speicherbauelement 6a ist mit einer Bitleitung 8 verbunden und das in der zweiten Speicherzellenlage befindliche magnetoresistive Speicherbauelement 6b ist an eine Bitleitung 9 angeschlossen. Die Wortleitung 7 sowie die beiden Bitleitungen 8, 9 verlaufen zueinander im wesentlichen senkrecht. Die Vielzahl von Wortleitungen 7 innerhalb des Speicherzellenfeldes 2 verlaufen zueinander im wesentlichen parallel. Auch die Vielzahl von Bitleitungen 8, 9 innerhalb der ersten und zweiten Speicherzellenlage verlaufen zueinander im wesentlichen parallel durch das Speicherzellenfeld 2. Die magnetoresistiven Speicherbauelemente 6a, 6b sowie die Wort- und Bitleitungen 7, 8, 9 zur Kontaktierung der magnetoresistiven Speicherbauelemente 6a, 6b sind in mehrere dielektrische Schichten 10a, 10b, 10c, 10d, 10e eingebettet. Diese dielektrischen Schichten bestehen vorzugsweise aus Siliciumnitrid oder Siliciumdioxid. Die Bitleitungen 8, 9 sowie die Wortleitungen 7 bestehen aus einem leitfähigen Material, vorzugsweise aus einem Metall.

Wie man aus Fig. 4 erkennen kann, ist die Bitleitung 8 der ersten Speicherzellenlage über eine Durchkontaktierung bzw. ein Via 11 mit einem n+dotierten Drainbereich eines Ansteuertransistors 13 verbunden. Der Ansteuertransistor 13 dient zum Anlegen eines Signals an die Bitleitung 8. Der Ansteuertransistor 13 weist neben dem n+dotierten Drainbereich einen n+dotierten Sourcebereich 14 auf, der elektrisch mit einem Teil 5a der Ansteuerlogik 5 verbunden ist. Der Ansteuertransistor 13 weist ferner einen Gate-Anschluß 15 auf, der durch ein Gate-Oxid 16 von dem P-dotierten Halbleitersubstrat 4 getrennt liegt.

Die Bitleitung 9 der zweiten Speicherzellenlage zur Kontaktierung des Speicherbauelements 6b ist über eine Durchkontaktierung 17 mit einer in der dielektrischen Schicht 10b eingebetteten Metallisierung 18 verbunden, die ihrerseits über eine Durchkontaktierung 19 mit einem n+-dotierten Sourcebereich 20 eines Ansteuertransistors 21 verbunden ist. Der Ansteuertransistors 21 weist neben dem n+dotierten Sourceanschlußbereich 20 einen n-dotierten Drainanschlußbereich 22 auf. Der Drainanschlußbereich 22 ist mit einem Teil 5b der Ansteuerlogik 5 verbunden. Der Ansteuertransistors 21 besitzt ferner einen Gate-Anschluß 23, der durch ein Gate-Oxid 24 von dem p-dotierten Halbleitersubstrat 4 getrennt liegt. Der Ansteuertransistor 21 ermöglicht das Anlegen eines Signals an die Bitleitung 9 der zweiten Speicherzellenlage innerhalb des Speicherzellenfeldes 2.

Bei den in Fig. 4 dargestellten Auswahltransistoren 13, 21 handelt es sich um N-Kanal-MOSFETS, die in ein p-dotiertes Halbleitersubstrat 4 eingebettet sind. Bei einer alternativen Ausführungsform können auch P-Kanal-MOSFETS als Auswahltransistoren eingesetzt werden, die in ein n-dotiertes Halbleitersubstrat 4 eingebettet sind. Bei Verwendung einer CMOS-Logik werden sowohl N - als auch P-Kanal-MOSFETS eingesetzt. Bei einer weiteren alternativen Ausführungsform können die Auswahltransistoren 13, 21 auch durch Bipolartransistoren gebildet werden.

Die Durchkontaktierungen 11, 17, 19 bestehen aus einem leitfähigen Material, wie beispielsweise aus Wolfram oder Kupfer. Sie werden vorzugsweise in einem Damasceneverfahren hergestellt. Dabei ist der Durchmesser der Durchkontaktierungen 11, 17, 19 vorzugsweise genau so groß wie die minimale Strukturgröße F, wobei die minimale lithographische Strukturgröße etwa im Bereich von 100 nm liegt. Die lateralen Abmessungen der magnetoresistiven Speicherbauelemente 6a, 6b liegen vorzugsweise, ebenfalls im Größenbereich von F, während ihre Dicken zwischen 20 und 40 nm liegen. Die Gesamtdicke eines zweilagigen Speicherzellenfeldes liegt vorzugsweise in einem Bereich zwischen 600 und 1500 nm. Speicherzellenfelder mit weiteren Speicherzellenlagen sind entsprechend dicker. Als Halbleitersubstrat 4 kann ein Siliziumsubstrat oder Gas-Substrat eingesetzt werden. Wie man aus Fig. 4 erkennen kann, ist die Ansteuerlogik 5 in das Halbleitersubstrat 4 integriert und über die beiden Steuertransistoren 13, 22 an die Bitleitungen 8, 9 zur Ansteuerung der Speicherbauelemente 6a, 6b angeschlossen. Die Ansteuerlogik 5, deren Schaltungsteile 5a, 5b gestrichelt in Fig. 4 angedeutet sind, befindet sich unterhalb des Speicherzellenfeldes 2. Die Ansteuerlogik 5 ist dabei vorzugsweise als CMOS-Logik aufgebaut.

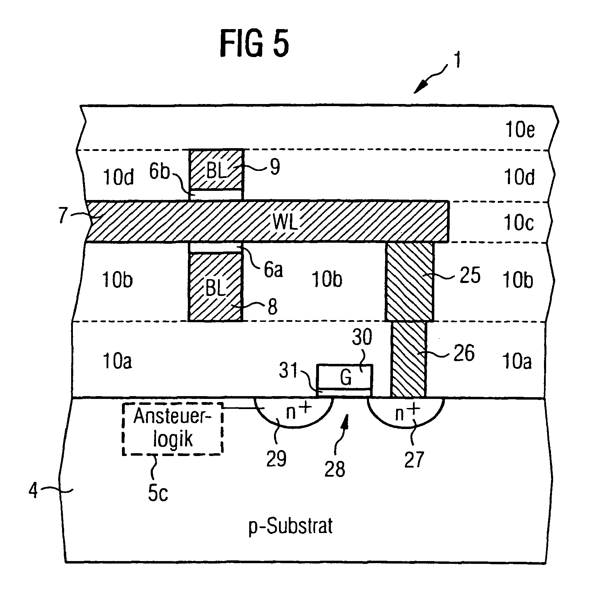

Fig. 5 zeigt eine weitere Schnittansicht durch den erfindungsgemäßen MRAM-Speicher 3 (wobei die in Fig. 5 dargestellte Schnittansicht senkrecht zu der in Fig. 4 dargestellten Schnittansicht verläuft).

Die Wortleitung 7 zur Kontaktierung der Speicherbauelemente 6a, 6b ist über eine Metallisierung 25, die in der dielektrischen Schicht 10b eingebettet ist, und über eine Durchkontaktierung 26 durch die dielektrische Schicht 10a mit einem n+-dotierten Sourceanschlußbereich 27 eines weiteren Ansteuertransistors 28 verbunden. Der Ansteuertransistors 28 weist einen n+dotierten Drainanschlußbereich 29 auf, der elektrisch mit einem Schaltungsteil 5c der Ansteuerlogik 5 verbunden ist. Der Ansteuertransistors 28 besitzt einen Gate-Anschluß 30, der durch ein Gate-Oxid 31 von dem p-dotierten Halbleitersubstrat 4 getrennt liegt. Die Ansteuerlogik 5 steuert über den Ansteuertransistors 28 und die Wortleitung 7 die in den Speicherzellenlagen befindlichen magnetoresistiven Speicherbauelemente 6a, 6b an. Die Wortleitung 7 dient dabei gleichzeitig der Ansteuerung der Speicherbauelemente 6a in der ersten Speicherzellenlage und der Speicherbauelemente 6b in der zweiten Speicherzellenlage.

Die Speicherbauelemente 6a, 6b weisen zwei ferromagnetische Schichten und eine dazwischen angeordnete nicht-magnetische Schicht auf. Dabei können die Speicherbauelemente 6a, 6b zwischen zwei Magnetisierungszuständen umgeschaltet werden. Die in den Speicherbauelementen 6a, 6b vorgesehenen ferromagnetische Schichten enthalten mindestens eines der Elemente Fe, Ni, Co, Cr, Mn, Gd, Dy. Die Dicke der ferromagnetischen Schichten liegt dabei unter 20 nm. Die in den Speicherbauelementen 6a, 6b enthaltene nicht-magnetische Schicht besteht vorzugsweise aus Al₂O₃, NiO, HfO₂, TiO₂, NbO, SiO₂ und weist eine Dicke auf, die in einem Bereich zwischen 1 und 4 nm liegt. Zusätzlich enthalten die Speicherbauelemente 6a, 6b eine antiferromagnetische Schicht, die parallel zu einer der ferromagnetische Schichten liegt, diese kontaktiert und die Magnetisierungsrichtung in dieser ferromagnetischen Schicht fixiert. Die antiferromagnetische Schicht der Speicherbauelemente 6a, 6b enthält dabei mindestens eines der Elemente Fe, Mn, Pt, Ni, Ir, Tb oder O.

Zum Einschreiben einer Information in ein Speicherbauelement 6a, 6b wird in die zugehörige Wortleitung 7 ein Strom I_{WL} und in die zugehörigen Bitleitungen 8, 9 ein Strom I_{BL} durch die Ansteuerlogik 5 eingeprägt. Diese Ströme induzieren um die Wortleitung 7 ein Magnetfeld H_{WL} und um die zugehörige Bitleitung 8, 9 ein Magnetfeld H_{BL}. Im Kreuzungsbereich von Bitleitung 8, 9 und der Wortleitung 7 ist das resultierende Magnetfeld hinreichend groß, um die Magnetisierung einer der beiden ferromagnetischen Schichten zu beeinflussen. Die Magnetisierung der anderen ferromagnetischen Schicht ist durch die antiferromagnetische Schicht, die zu der zweiten ferromagnetischen Schicht benachbart liegt, festgelegt.

Zum Auslesen einer Information aus einem Speicherbauelement 6a, 6b sind sämtliche Methoden anwendbar, die für herkömmliche MRAM-Speicher mit peripherer Ansteuerlogik möglich sind.

Bei dem erfindungsgemäßen magnetoresistiven MRAM-Speicher 1 kann eine Vielzahl von Speicherzellenlagen übereinander auf das Halbleitersubstrat 4 gestapelt werden. In jeder Speicherzellenlage befinden sich eine Vielzahl von magnetoresistiven Speicherbauelementen 6a, 6b, die über Wortleitungen und Bitleitungen angesteuert werden, wobei die Wort- und Bitleitungen zueinander im wesentlichen senkrecht verlaufen. Die Speicherbauelemente 6a, 6b weisen dabei sehr geringe Abmessungen in einem Bereich zwischen 0,5 und 20 µm auf, weil die magnetoresistiven Speicherbauelemente im Gegensatz zu DRAM-Speicherzellen keinen eigenen integrierten Auswahltransistor benötigen. Die geringe Größe eines Speicherbauelements ermöglicht eine extrem hohe Packungsdichte innerhalb des Speicherzellenfeldes 2 des erfindungsgemäßen MRAM-Speichers 1. Die Ansteuerlogik 5 wird bei dem erfindungs-gemäßen MRAM-Speicher 1 nicht an der Peripherie angeordnet, sondern unterhalb des Speicherzellenfeldes 2. Die Ansteuerlogik 5 ist dabei durch Ansteuertransistoren und Durchkontaktierungen mit den Wort- und Bitleitungen 7, 8, 9 verbunden und liegt integriert in dem Halbleitersubstrat 4 des MRAM-Speichers 1. Dadurch wird eine weitere Reduzierung der Größe des MRAM-Speichers erzielt. Der erfindungsgemäße MRAM-Speicher 1 besitzt daher eine extrem hohe Speicherkapazität bei gleichzeitig minimalen Flächenverbrauch auf dem Halblei-tersubstrat 4.

Aufgrund der Flächenersparnis bei dem erfindungsgemäßen MRAM-Speicher 1 können die Herstellungskosten stark abgesenkt werden. Darüberhinaus verkürzen sich die Signalwege, wodurch der erfindungsgemäße MRAM-Speicher schneller arbeitet. Die in den Fig. 4, 5 dargestellten elektrischen Verbindungen zwischen der Ansteuerlogik 5 über die Ansteuertransistoren 13, 21, 28 zu den Wort- und Bitleitungen 7, 8, 9 müssen nicht am Rande des Speicherzellenfeldes 2 und unterhalb derselben angeordnet sein, sondern befinden sich bei weiteren Ausführungsformen auch innerhalb bzw. mitten unterhalb des Speicherzellenfeldes 2. Hierdurch können die Signallaufzeiten zu den Speicherbauelementen 6a, 6b innerhalb des Speicherzellenfeldes 2 weiter verkürzt werden. Der erfindungsgemäße MRAM-Speicher 1 zeichnet sich daher im Vergleich zu einem herkömmlichen MRAM-Speicher durch besonders kurze Signallaufzeiten und somit kurze Speicherzugriffszeiten aus.

### Bezugszeichenliste:

- 1: MRAM-Speicher
- 2: Speicherzellenfeld
- 3: Kontaktierungsauffächerung
- 4: Halbleitersubstrat
- 5: Ansteuerlogik
- 6a: Speicherbaulement
- 6b: Speicherbaulement
- 7: Wortleitung
- 8: Bitleitung
- 9: Bitleitung
- 10a: dielektrische Schicht
- 10b: dielektrische Schicht
- 10c: dielektrische Schicht
- 10d: dielektrische Schicht
- 10e: dielektrische Schicht
- 11: Durchkontaktierung
- 12: Drainanschlußbereich
- 13: Ansteuertransistor
- 14: Sourceanschlußbereich
- 15: Gate-Anschluß
- 16: Gate-Oxid
- 17: Durchkontaktierung
- 18: Metallisierung
- 19: Durchkontaktierung
- 20: Sourceanschlußbereich
- 21: Ansteuertransistor
- 22: Drainanschlußbereich
- 23: Gate-Anschluß
- 24: Gate-Oxid
- 25: Metallisierung
- 26: Durchkontaktierung
- 27: Sourceanschlußbereich
- 28: Ansteuertransistor
- 29: Drainanschlußbereich
- 30: Gate-Anschluß
- 31: Gate-Oxid

## Patentansprüche

1. MRAM-Speicher mit
a) einem Speicherzellenfeld (2), das aus magnetoresistiven Speicherbauelementen (6a, 6b) besteht, die in mindestens einer Speicherzellenlage über einem Halbleitersubstrat (4) angeordnet sind;
b) Wortleitungen (7) und senkrecht dazu verlaufende Bitleitungen (8, 9) zur Kontaktierung der magnetoresistiven Speicherbauelemente (6a, 6b) in dem Speicherzellenfeld (2),
wobei die Speicherbauelemente (6a, 6b) jeweils zwischen einer Wortleitung (7) und einer kreuzenden Bitleitung (8, 9) liegen;
**gekennzeichnet durch**
c) eine Ansteuerlogik (5a, 5b, 5c) zur Ansteuerung der magnetoresistiven Speicherbauelemente (6a, 6b) in dem Speicherzellenfeld (2) über die Wort- und Bitleitungen (7, 8, 9), wobei die Ansteuerlogik (5a, 5b, 5c) unterhalb des Speicherzellenfeldes (2) in und auf dem Halbleitersubstrat (4) integriert ist,
d) wobei jede Wortleitung (7) und jede Bitleitung (9) jeweils über einen zugehörigen Leitungs-Ansteuertransistor (13, 21, 28) mit der Ansteuerlogik (5a, 5b, 5c) verbunden ist,
e) wobei die Ansteuerlogik zum Einschreiben eines Datums in ein Speicherbauelement (6a, 6b) des Speicherzellenfeldes (2) den Wortleitungs-Ansteuertransistor (28) und den Bitleitungs-Ansteuertransistor (13, 21) derjenigen Wortleitung (7) und derjenigen, die Wortleitung (7) kreuzenden Bitleitung (8, 9) ansteuert, zwischen denen das Speicherbauelement (6a, 6b) liegt.

2. MRAM-Speicher nach Anspruch 1,
**dadurch gekennzeichnet,**
**dass** die magnetoresistiven Speicherbauelemente (6a, 6b) und die Wort- und Bitleitungen (7, 8, 9) zur Kontaktierung der magnetoresistiven Speicherbauelemente (6a, 6b) in mehreren dielektrischen Schichten (10a, 10b, 10c, 10e) eingebettet sind.

3. MRAM-Speicher nach einem der vorhergehenden Ansprüche,
**dadurch gekennzeichnet,**
**dass** die Wort- und Bitleitungen (7, 8, 9) über Durchkontaktierungen (11, 17, 19, 26) durch die dielektrischen Schichten (10a, 10 c) mit der im Halbleitersubstrat (4) integrierten Ansteuerlogik (5a, 5b, 5c) verbunden sind.

4. MRAM-Speicher nach einem der vorhergehenden Ansprüche,
**dadurch gekennzeichnet,**
**dass** die Durchmesser der Durchkontaktierungen (11, 17, 19, 26) etwa der minimalen Strukturgröße F entsprechen.

5. MRAM-Speicher nach einem der vorhergehenden Ansprüche,
**dadurch gekennzeichnet,**
**dass** die Ansteuerlogik (5a, 5b, 5c) eine CMOS-Logik ist.

6. MRAM-Speicher nach einem der vorhergehenden Ansprüche,
**dadurch gekennzeichnet,**
**dass** die Speicherbauelemente (6a, 6b) jeweils zwei ferromagnetische Schichten und eine dazwischen angeordnete nicht-magnetische Schicht aufweisen.

7. MRAM-Speicher nach einem der vorhergehenden Ansprüche,
**dadurch gekennzeichnet,**
**dass** die Speicherbauelemente (6a, 6b) jeweils zwei Magnetisierungszustände aufweisen.

8. MRAM-Speicher nach einem der vorhergehenden Ansprüche,
**dadurch gekennzeichnet,**
**dass** die beiden ferromagnetischen Schichten jeweils mindestens eines der Elemente Fe, Ni, Co, Cr, Mn, Gd, Dy enthalten.

9. MRAM-Speicher nach einem der vorhergehenden Ansprüche,
**dadurch gekennzeichnet,**
**dass** die beiden ferromagnetischen Schichten eine Dicke aufweisen, die kleiner oder gleich 20 nm ist.

10. MRAM-Speicher nach einem der vorhergehenden Ansprüche,
**dadurch gekennzeichnet,**
**dass** die nicht-magnetische Schicht mindestens eines der Materialien A1203, Ni0, Hf02, Ti02, Nb0, Si02 enthält.

11. MRAM-Speicher nach einem der vorhergehenden Ansprüche,
**dadurch gekennzeichnet,**
**dass** die nicht-magnetische Schicht eines Speicherbauelements (6a, 6b) eine Dicke im Bereich zwischen 1 und 4 nm aufweist.

12. MRAM-Speicher nach einem der vorhergehenden Ansprüche,
**dadurch gekennzeichnet,**
**dass** die Speicherbauelemente (6a, 6b) eine antiferromagnetische Schicht aufweist, die eine der ferromagnetischen Schicht benachbart liegen.

13. MRAM-Speicher nach einem der vorhergehenden Ansprüche,
**dadurch gekennzeichnet,**
**dass** die antiferromagnetische Schicht mindestens eines der Elemente Fe, Mn, Pt, Ni, Ir, Tb oder O enthält.

14. MRAM-Speicher nach einem der vorhergehenden Ansprüche,
**dadurch gekennzeichnet,**
**dass** die Speicherbauelemente Abmessungen in einem Bereich zwischen 0,5 µm und 20 µm aufweisen.

15. MRAM-Speicher nach einem der vorhergehenden Ansprüche,
**dadurch gekennzeichnet,**
**dass** die Bitleitungen (8, 9) jeweils mit einem Leseverstärker verbunden sind.

16. MRAM-Speicher nach einem der vorhergehenden Ansprüche,
**dadurch gekennzeichnet,**
**dass** die Gesamtdicke der übereinanderliegenden Speicherzellenlagen zwischen 400 und 1000 nm liegt.

17. MRAM-Speicher nach einem der vorhergehenden Ansprüche,
**dadurch gekennzeichnet,**
**dass** die Wortleitungen (7) jeweils mit Speicherbauelemente (6a, 6b) in zwei übereinanderliegenden Speicherzellenlagen verbunden sind.

18. MRAM-Speicher nach einem der vorhergehenden Ansprüche,
**dadurch gekennzeichnet**,
wobei die Leitungs-Ansteuertransistoren (13, 21, 28) am Rande des Speicherzellenfeldes (2) angeordnet sind.

## Claims

1. MRAM memory having
(a) a memory cell array (2) comprising magnetoresistive memory components (6a, 6b) arranged in at least one memory cell layer above a semiconductor substrate (4);
(b) word lines (7) and - running perpendicularly thereto - bit lines (8, 9) for making contact with the magnetoresistive memory components (6a, 6b) in the memory cell array (2),
the memory components (6a, 6b) in each case lying between a word line (7) and a crossing bit line (8, 9);
**characterized by**
(c) a drive logic arrangement (5a, 5b, 5c) for driving the magnetoresistive memory components (6a, 6b) in the memory cell array (2) via the word and bit lines (7, 8, 9), the drive logic arrangement (5a, 5b, 5c) being integrated below the memory cell array (2) in and on the semiconductor substrate (4),
(d) each word line (7) and each bit line (9) in each case being connected to the drive logic arrangement (5a, 5b, 5c) via an associated line drive transistor (13, 21, 28),
(e) the drive logic arrangement, for writing a datum to a memory component (6a, 6b) of the memory cell array (2), driving the word line drive transistor (28) and the bit line drive transistor (13, 21) of that word line (7) and of that bit line (8, 9) crossing the word line (7), between which the memory component (6a, 6b) lies.

2. MRAM memory according to Claim 1,
**characterized**
**in that** the magnetoresistive memory components (6a, 6b) and the word and bit lines (7, 8, 9) for making contact with the magnetoresistive memory components (6a, 6b) are embedded in a plurality of dielectric layers (10a, 10b, 10c, 10e).

3. MRAM memory according to one of the preceding claims,
**characterized**
**in that** the word and bit lines (7, 8, 9) are connected via plated-through holes (11, 17, 19, 26) through the dielectric layers (10a, 10c) to the drive logic arrangement (5a, 5b, 5c) integrated in the semiconductor substrate (4).

4. MRAM memory according to one of the preceding claims,
**characterized**
**in that** the diameters of the plated-through holes (11, 17, 19, 26) approximately correspond to the minimum feature size F.

5. MRAM memory according to one of the preceding claims,
**characterized**
**in that** the drive logic arrangement (5a, 5b, 5c) is a CMOS logic arrangement.

6. MRAM memory according to one of the preceding claims,
**characterized**
**in that** the memory components (6a, 6b) each have two ferromagnetic layers and a nonmagnetic layer arranged in between.

7. MRAM memory according to one of the preceding claims,
**characterized**
**in that** the memory components (6a, 6b) each have two magnetization states.

8. MRAM memory according to one of the preceding claims,
**characterized**
**in that** the two ferromagnetic layers each contain at least one of the elements Fe, Ni, Co, Cr, Mn, Gd, Dy.

9. MRAM memory according to one of the preceding claims,
**characterized**
**in that** the two ferromagnetic layers have a thickness which is less than or equal to 20 nm.

10. MRAM memory according to one of the preceding claims,
**characterized**
**in that** the nonmagnetic layer contains at least one of the materials Al2O3, NiO, Hf02, Ti02, NbO, SiO2.

11. MRAM memory according to one of the preceding claims,
**characterized**
**in that** the nonmagnetic layer of a memory component (6a, 6b) has a thickness in the range between 1 and 4 nm.

12. MRAM memory according to one of the preceding claims,
**characterized**
**in that** the memory components (6a, 6b) have an antiferromagnetic layer adjacent to one of the ferromagnetic layers.

13. MRAM memory according to one of the preceding claims,
**characterized**
**in that** the antiferromagnetic layer contains at least one of the elements Fe, Mn, Pt, Ni, Ir, Tb or O.

14. MRAM memory according to one of the preceding claims,
**characterized**
**in that** the memory components have dimensions in a range between 0.5 µm and 20 µm.

15. MRAM memory according to one of the preceding claims,
**characterized**
**in that** the bit lines (8, 9) are each connected to a sense amplifier.

16. MRAM memory according to one of the preceding claims,
**characterized**
**in that** the total thickness of the memory cell layers lying one above the other is between 400 and 1000 nm.

17. MRAM memory according to one of the preceding claims,
**characterized**
**in that** the word lines (7) are each connected to memory components (6a, 6b) in two memory cell layers lying one above the other.

18. MRAM memory according to one of the preceding claims,
**characterized**
**in that** the line drive transistors (13, 21, 28) are arranged at the edge of the memory cell array (2).

## Revendications

1. Mémoire MRAM, comprenant
a) un champ de cellules de mémoire (2) qui se compose de modules de mémoire magnétorésistifs (6a, 6b) qui sont disposés dans au moins une couche de cellules de mémoire au-dessus d'un substrat en semi-conducteur (4) ;
b) des lignes de mots (7) et des lignes de bits (8, 9) s'étendant de façon perpendiculaire à celles-ci pour la mise en contact des modules de mémoire magnétorésistifs (6a, 6b) dans le champ de cellules de mémoire (2),
les modules de mémoire (6a, 6b) se situant respectivement entre une ligne de mots (7) et une ligne de bits (8, 9) de croisement ;
**caractérisée par**
c) une logique d'excitation (5a, 5b, 5c) pour exciter les modules de mémoire magnétorésistifs (6a, 6b) dans le champ de cellules de mémoire (2) par l'intermédiaire des lignes de mots et de bits (7, 8, 9), la logique d'excitation (5a, 5b, 5c) étant intégrée au-dessous du champ de cellules de mémoire (2) dans et sur le substrat en semi-conducteur (4),
d) chaque ligne de mots (7) et chaque ligne de bits (9) étant respectivement reliée à la logique d'excitation (5a, 5b, 5c) par un transistor d'excitation de ligne (13, 21, 28) associé,
e) dans laquelle, pour l'inscription d'une donnée dans un module de mémoire (6a, 6b) du champ de cellules de mémoire (2), la logique d'excitation excite le transistor d'excitation de ligne de mots (28) et le transistor d'excitation de ligne de bits (13, 21) de la ligne de mots (7) et de la ligne de bits (8, 9) croisant la ligne de mots (7) entre lesquelles se trouve le module de mémoire (6a, 6b).

2. Mémoire MRAM selon la revendication 1, **caractérisée en ce que** les modules de mémoire magnétorésistifs (6a, 6b) et les lignes de mots et de bits (7, 8, 9) sont noyées dans plusieurs couches diélectriques (10a, 10b, 10c, 10e) pour la mise en contact des modules de mémoire magnétorésistifs (6a, 6b).

3. Mémoire MRAM selon l'une quelconque des revendications précédentes, **caractérisée en ce que** les lignes de mots et de bits (7, 8, 9) sont reliées à la logique d'excitation (5a, 5b, 5c) intégrée dans le substrat en semi-conducteur (4) par l'intermédiaire de trous métallisés (11, 17, 19, 26) à travers les couches diélectriques (10a, 10c).

4. Mémoire MRAM selon l'une quelconque des revendications précédentes, **caractérisée en ce que** les diamètres des trous métallisés (11, 17, 19, 26) correspondent approximativement à la dimension structurelle minimale F.

5. Mémoire MRAM selon l'une quelconque des revendications précédentes, **caractérisée en ce que** la logique d'excitation (5a, 5b, 5c) est une logique CMOS.

6. Mémoire MRAM selon l'une quelconque des revendications précédentes, **caractérisée en ce que** les modules de mémoire (6a, 6b) présentent respectivement deux couches ferromagnétiques et une couche non magnétique disposée entre celles-ci.

7. Mémoire MRAM selon l'une quelconque des revendications précédentes, **caractérisée en ce que** les modules de mémoire (6a, 6b) présentent respectivement deux états d'aimantation.

8. Mémoire MRAM selon l'une quelconque des revendications précédentes, **caractérisée en ce que** les deux couches ferromagnétiques comprennent respectivement au moins l'un des éléments Fe, Ni, Co, Cr, Mn, Gd, Dy.

9. Mémoire MRAM selon l'une quelconque des revendications précédentes, **caractérisée en ce que** les deux couches ferromagnétiques présentent une épaisseur qui est inférieure ou égale à 20 nm.

10. Mémoire MRAM selon l'une quelconque des revendications précédentes, **caractérisée en ce que** la couche non magnétique comprend au moins l'un des matériaux Al₂O₃, NiO, HfO₂, TiO₂, NbO, SiO₂.

11. Mémoire MRAM selon l'une quelconque des revendications précédentes, **caractérisée en ce que** la couche non magnétique d'un module de mémoire (6a, 6b) présente une épaisseur dans la plage comprise entre 1 et 4 nm.

12. Mémoire MRAM selon l'une quelconque des revendications précédentes, **caractérisée en ce que** les modules de mémoire (6a, 6b) présentent une couche antiferromagnétique qui est située de façon adjacente à l'une des couches ferromagnétiques.

13. Mémoire MRAM selon l'une quelconque des revendications précédentes, **caractérisée en ce que** la couche antiferromagnétique comprend au moins l'un des éléments Fe, Mn, Pt, Ni, Ir, Tb ou O.

14. Mémoire MRAM selon l'une quelconque des revendications précédentes, **caractérisée en ce que** les modules de mémoire présentent des dimensions dans une plage comprise entre 0,5 µm et 20 µm.

15. Mémoire MRAM selon l'une quelconque des revendications précédentes, **caractérisée en ce que** les lignes de bits (8, 9) sont reliées respectivement à un amplificateur de lecture.

16. Mémoire MRAM selon l'une quelconque des revendications précédentes, **caractérisée en ce que** l'épaisseur totale des couches de cellules de mémoire superposées se situe entre 400 et 1000 nm.

17. Mémoire MRAM selon l'une quelconque des revendications précédentes, **caractérisée en ce que** les lignes de mots (7) sont reliées respectivement à des modules de mémoire (6a, 6b) dans deux couches de cellules de mémoire superposées.

18. Mémoire MRAM selon l'une quelconque des revendications précédentes, **caractérisée en ce que** les transistors d'excitation de ligne (13, 21, 28) sont disposés au bord du champ de cellules de mémoire (2).
